# EUROPEAN PATENT APPLICATION

(11) **EP 3 923 288 A1**
(43) Date of publication of application: **15.12.2021**
(21) Application number: 19916906.1
(22) Date of filing: 28.02.2019
(51) Int. Cl.: G11C 11/16

(54) **MEMORY AND ACCESS METHOD**

(71) Applicant: Huawei Technologies Co., Ltd., Longgang Shenzhen, Guangdong 518129 (CN)
(72) Inventor: XU, Jeffrey Junhao, Shenzhen, Guangdong 518129 (CN); YANG, Huan, Shenzhen, Guangdong 518129 (CN); ZHANG, Riqing, Shenzhen, Guangdong 518129 (CN)
(74) Representative: Epping - Hermann - Fischer
(86) International application number: PCT/CN2019/076591
(87) International publication number: WO 2020/172891

(57) **Abstract**

This application provides a magneto-resistive random access memory, to reduce a chip area. The magneto-resistive random access memory includes: a plurality of stacked stacking layers, where each stacking layer includes a plurality of magnetic memory cells arranged in a two-dimensional manner; and a plurality of selective metal layers, where each stacking layer is disposed between two selective metal layers and is adjacent to the two selective metal layers, and each selective metal layer is connected to a magnetic memory cell in an adjacent stacking layer, and is configured to perform a read/write operation on the magnetic memory cell.

## Description

### TECHNICAL FIELD

This application relates to the storage field, and in particular, to a memory and an access method.

### BACKGROUND

A magneto-resistive random access memory (magneto-resistive random access memory, MRAM) is currently a hot research topic in the industry. The magneto-resistive random access memory is a non-volatile memory (non-volatile memory), and records logic states "0" and" 1" based on different magneto-resistance caused by different magnetization directions. If an external magnetic field does not change, a magnetization direction does not change. Therefore, when retaining data, the magneto-resistive random access memory does not need to perform a refresh operation all the time, and has an advantage of low power consumption.

The magneto-resistive random access memory may replace a dynamic random access memory (dynamic random access memory, DRAM) as a high-performance computing memory, for example, as a third-layer or fourth-layer cache. However, with development of technologies, an application field has an increasingly high requirement for a high-performance general-purpose memory. For example, a memory is expected to support more read and write times and have lower power consumption, lower costs, a smaller volume, and a higher density. Therefore, a method for optimizing performance of the magneto-resistive random access memory has been explored in the industry.

### SUMMARY

This application provides a memory and an access method, to reduce a chip area.

According to a first aspect, a memory is provided, including: a memory layer, where a plurality of magnetic memory cells are disposed in the memory layer; and two metal layers adjacent to the memory layer, where the two metal layers are separately located on two sides of the memory layer, the two metal layers include metallic wires, and the metallic wires in the two metal layers are separately coupled to two poles of the magnetic memory cell in the memory layer. In this embodiment of this application, a memory structure is provided. The metal layers are disposed on the two sides of the memory layer in the structure, and coupled to the two poles of the magnetic memory cell in the memory layer. The structure can enable the memory to have a higher storage density, thereby reducing a chip area and chip costs. With reference to the first aspect, in a possible implementation, orientations of the magnetic memory cells in the memory layer are the same.

With reference to the first aspect, in a possible implementation, the magnetic memory cells in the memory layer are arranged in a two-dimensional matrix.

With reference to the first aspect, in a possible implementation, each of the two metal layers includes a plurality of metallic wires disposed in parallel, and the two metal layers include a first metal layer and a second metal layer. The plurality of metallic wires in the first metal layer are in a one-to-one correspondence with a plurality of rows in the two-dimensional matrix, and the metallic wire in the first metal layer is coupled to a first pole of a magnetic memory cell in a corresponding row. The plurality of metallic wires in the second metal layer are in a one-to-one correspondence with a plurality of columns in the two-dimensional matrix, and the metallic wire in the second metal layer is coupled to a second pole of a magnetic memory cell in a corresponding column.

With reference to the first aspect, in a possible implementation, the magnetic memory cell is disposed at a cross point between the metallic wire in the first metal layer and the metallic wire in the second metal layer.

In this embodiment of this application, the magnetic memory cell may be located at a position of the cross point between the metallic wire in the first metal layer and the metallic wire in the second metal layer, thereby increasing the storage density and reducing the chip area.

With reference to the first aspect, in a possible implementation, the magnetic memory cell includes a plurality of memory layers and a plurality of metal layers, and each of the plurality of memory layers includes a plurality of memory cells. Each memory layer is disposed between two metal layers and is adjacent to the two metal layers, the two metal layers include metallic wires, and the metallic wires in the two metal layers are separately coupled to two poles of the magnetic memory cell in each memory layer.

In this embodiment of this application, the memory structure may be a three-dimensional structure in which the plurality of memory layers and the plurality of metal layers are stacked, so that the memory can have a higher storage density, thereby reducing the chip area and the chip costs.

With reference to the first aspect, in a possible implementation, magnetic memory cells in two adjacent memory layers are distributed in a mirrored manner.

In this embodiment of this application, the magnetic memory cells in the adjacent memory layers are distributed in the mirrored manner. In this way, same poles of the memory cells in the adjacent memory layers are distributed oppositely, and metallic wires in a metal layer between the adjacent memory layers are coupled to the same poles of the memory cells in the adjacent memory layers, thereby avoiding a problem of disturbing a magnetic memory cell in an adjacent memory layer during a read/write operation.

With reference to the first aspect, in a possible implementation, orientations of magnetic memory cells in two adjacent memory layers are the same.

With reference to the first aspect, in a possible implementation, the magnetic memory cell is a magnetic memory cell supporting a voltage-controlled write operation.

In this embodiment of this application, in a manner of supporting the voltage-controlled write operation, an area of a single magnetic memory cell in the memory layer is less than an area of another type of magnetic memory cell, and the magnetic memory cell supporting a voltage-controlled write operation uses a three-dimensional stacking solution. Therefore, the three-dimensional stacking magneto-resistive random access memory in this embodiment of this application can have a higher storage density, thereby reducing the chip area and the chip costs.

With reference to the first aspect, in a possible implementation, the first pole of the magnetic memory cell is a free ferromagnetic layer end, and the second pole of the magnetic memory cell is a fixed ferromagnetic layer end. When a first negative voltage is applied to a first pole of a first magnetic memory cell, and a first positive voltage is applied to a second pole of the first magnetic memory cell, the first magnetic memory cell performs a write operation, where a voltage difference between the first positive voltage and the first negative voltage is a write-operation voltage of the magnetic memory cell, and the first magnetic memory cell is any one of the plurality of magnetic memory cells. With reference to the first aspect, in a possible implementation, the first positive voltage is equal to +Vw/2, and the first negative voltage is equal to -Vw/2, where Vw represents the write-operation voltage of the magnetic memory cell.

With reference to the first aspect, in a possible implementation, the first pole of the magnetic memory cell is a free ferromagnetic layer end, and the second pole of the magnetic memory cell is a fixed ferromagnetic layer end. When a second positive voltage is applied to a first pole of a first magnetic memory cell, and a second negative voltage is applied to a second pole of the first magnetic memory cell, the first magnetic memory cell performs a read operation, where a voltage difference between the second positive voltage and the second negative voltage is a read-operation voltage of the magnetic memory cell, and the first magnetic memory cell is any one of the plurality of magnetic memory cells.

With reference to the first aspect, in a possible implementation, the second positive voltage is equal to +V_{R}/2, and the second negative voltage is equal to -V_{R}/2, where V_{R} represents the read-operation voltage of the magnetic memory cell.

With reference to the first aspect, in a possible implementation, the magnetic memory cell includes a free ferromagnetic layer, a fixed ferromagnetic layer, and a magnetic tunnel barrier. The magnetic tunnel barrier is located between the fixed ferromagnetic layer and the free ferromagnetic layer, and includes a first barrier layer, a conductive layer, and a second barrier layer.

In this embodiment of this application, a new magnetic memory cell structure is provided. In the structure, a quantum well structure with two tunnel barriers is used to replace a conventional magnetic tunnel barrier structure with a single barrier. By using a negative differential resistance characteristic of a quantum well with two tunnel barriers, a write-operation voltage may be set to be higher than a read-operation voltage, thereby meeting a requirement of optimizing write-operation performance. In addition, because a current corresponding to the read-operation voltage is comparatively large, and a corresponding resistance value is comparatively small, an impact of an RC delay on a speed of a read operation is reduced.

With reference to the first aspect, in a possible implementation, the first barrier layer and the second barrier layer include a dielectric, and the conductive layer includes a conductive material.

With reference to the first aspect, in a possible implementation, the first barrier layer and the second barrier layer include a crystalline metal oxide.

With reference to the first aspect, in a possible implementation, a material used by the first barrier layer and the second barrier layer includes a magnesium oxide MgO, and a material used by the conductive layer includes cobalt iron boron CoFeB.

With reference to the first aspect, in a possible implementation, the conductive layer includes any one or any combination of the following materials: cobalt ironboron (CoFeB), cobalt iron (CoFe), iron (Fe), cobalt (Co), platinum (Pt), and tantalum (Ta).

With reference to the first aspect, in a possible implementation, the conductive layer includes any one or any combination of the following materials: silicon (Si), silicon germanium (SiGe), germanium (Ge), a II-VI compound, and a III-V compound.

With reference to the first aspect, in a possible implementation, materials of the first barrier layer and the second barrier layer include any one or any combination of the following materials: a magnesium oxide (MgO), an aluminum oxide (AlO), an aluminum nitride (AlN), a boron nitride (BN), and a silicon oxide (SiO2).

With reference to the first aspect, in a possible implementation, the magnetic tunnel barrier has a symmetrical structure. According to a second aspect, a memory access method is provided. A memory includes: a memory layer, where a plurality of magnetic memory cells are disposed in the memory layer, and two metal layers adjacent to the memory layer, where the two metal layers are separately located on two sides of the memory layer, the two metal layers include metallic wires, and the metallic wires in the two metal layers are separately coupled to two poles of the magnetic memory cell in the memory layer. A first pole of the magnetic memory cell is a free ferromagnetic layer end, and a second pole of the magnetic memory cell is a fixed ferromagnetic layer end. The method includes: when a write operation is performed, applying a first negative voltage to a metallic wire connected to a first pole of a first magnetic memory cell, and applying a first positive voltage to a metallic wire connected to a second pole of the first magnetic memory cell, where the first magnetic memory cell is any one of the plurality of magnetic memory cells, and a voltage difference between the first positive voltage and the first negative voltage is a write-operation voltage of the magnetic memory cell; or when a read operation is performed, applying a second positive voltage to a metallic wire connected to a first pole of a first magnetic memory cell, and applying a second negative voltage to a metallic wire connected to a second pole of the first magnetic memory cell, where a voltage difference between the second positive voltage and the second negative voltage is a read-operation voltage of the magnetic memory cell.

In this embodiment of this application, the method for accessing the magneto-resistive random access memory that uses a structure in which the memory layer and the adjacent metal layers are stacked is provided. The method can implement read and write operations for the magneto-resistive random access memory with the structure.

With reference to the second aspect, in a possible implementation, the first positive voltage is equal to +Vw/2, and the first negative voltage is equal to -Vw/2, where Vw represents the write-operation voltage of the magnetic memory cell.

With reference to the second aspect, in a possible implementation, the second positive voltage is equal to +V_{R}/2, and the second negative voltage is equal to ―V_{R}/2, where V_{R} represents the read-operation voltage of the magnetic memory cell.

According to a third aspect, an integrated circuit is provided, including the memory according to any one of the first aspect or the possible implementations of the first aspect.

### BRIEF DESCRIPTION OF DRAWINGS

FIG. 1 is a schematic structural diagram of a magneto-resistive random access memory cell supporting a voltage-controlled write operation according to an embodiment of this application;
FIG. 2 is a schematic structural diagram of a magneto-resistive random access memory cell according to still another embodiment of this application;
FIG. 3 is a schematic diagram of energy level distribution of a quantum well with two tunnel barriers according to an embodiment of this application;
FIG. 4 is a voltage-current characteristic diagram of the quantum well with two tunnel barriers according to an embodiment of this application;
FIG. 5 is a voltage-current characteristic diagram of a quantum well with two tunnel barriers according to still another embodiment of this application;
FIG. 6 is a schematic diagram of a write operation of a magneto-resistive random access memory cell according to an embodiment of this application;
FIG. 7 is a schematic diagram of a read operation of a magneto-resistive random access memory cell according to an embodiment of this application;
FIG. 8 is a schematic architectural diagram of a three-dimensional stacking magneto-resistive random access memory according to an embodiment of this application;
FIG. 9 is a schematic architectural diagram of a three-dimensional stacking magneto-resistive random access memory according to still another embodiment of this application;
FIG. 10 is a schematic diagram of a write operation of a magneto-resistive random access memory according to still another embodiment of this application;
FIG. 11 is a potential distribution diagram of magnetic memory cells during a write operation according to the embodiment of this application;
FIG. 12 is a schematic diagram of a read operation of a magneto-resistive random access memory according to still another embodiment of this application; and
FIG. 13 is a potential distribution diagram of magnetic memory cells a the read operation according to the embodiment of this application.

### DESCRIPTION OF EMBODIMENTS

The following describes technical solutions of this application with reference to accompanying drawings.

A magneto-resistive random access memory supporting a voltage-controlled write operation in the embodiments of this application is first described. Optionally, the MRAM supporting a voltage-controlled write operation may also be referred to as a voltage-controlled magnetically anisotropic magneto-resistive random access memory (voltage-controlled magnetic anisotropy MRAM, VCMA-MRAM). Optionally, in the embodiments of this application, a magneto-resistive random access memory cell may also be referred to as a magnetic memory cell.

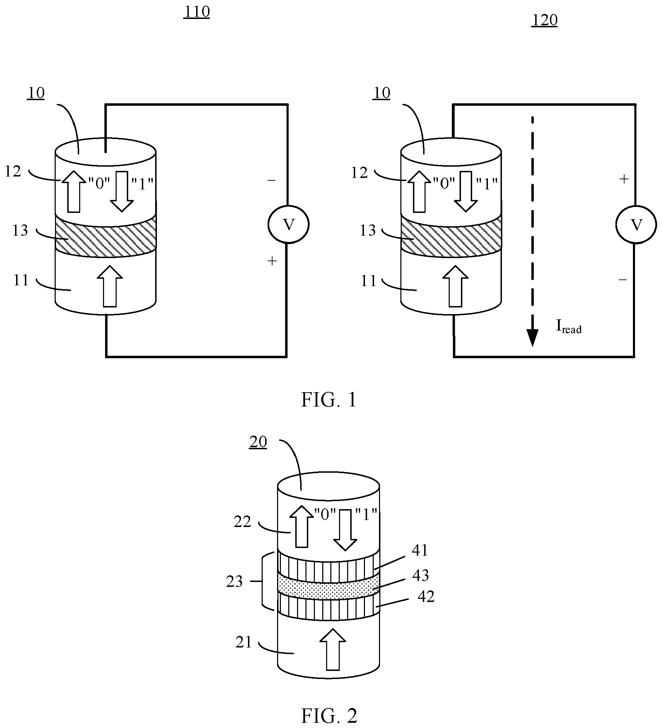

FIG. 1 is a schematic structural diagram of a magneto-resistive random access memory cell 10 supporting a voltage-controlled write operation according to an embodiment of this application. Apart 110 in FIG. 1 is a schematic diagram of a write operation, and a part 120 in FIG. 1 is a schematic diagram of a read operation. A hollow arrow in FIG. 1 is used to indicate a direction of a magnetic moment of a fixed ferromagnetic layer 11 or a direction of a magnetic moment of a free ferromagnetic layer 12. A core part of a magneto-resistive random access memory is a magneto-resistive random access memory cell. As shown in FIG. 1, the magneto-resistive random access memory cell 10 may include a magnetic tunnel junction (magnetic tunnel junction) that includes one fixed ferromagnetic layer 11, one magnetic tunnel barrier 13, and one free ferromagnetic layer 12. The magnetic tunnel barrier 13 may also be referred to as a magnetic tunnel barrier layer. The magnetic moment of the fixed ferromagnetic layer 11 is fixed, and the magnetic moment of the free ferromagnetic layer 12 is reversible. The arrow in FIG. 1 indicates the direction of the magnetic moment of the fixed ferromagnetic layer 11 or the direction of the magnetic moment of the free ferromagnetic layer 12. Therefore, logic states "0" and "1" may be separately recorded based on different magneto-resistance values caused by different directions of the magnetic moment of the free ferromagnetic layer 12. For example, as shown in FIG. 1, if the directions of the magnetic moments of the fixed ferromagnetic layer 11 and the free ferromagnetic layer 12 are the same, a resistance value of the magnetic tunnel junction is comparatively small, and the logic state "0" may be recorded; or if the directions of the magnetic moments of the fixed ferromagnetic layer 11 and the free ferromagnetic layer 12 are opposite, a resistance value of the magnetic tunnel junction is comparatively large, and the logic state "1" may be recorded. In this embodiment of the present invention, that the logic state "0" or "1" corresponds to a small or large resistance value of the magnetic tunnel junction is merely an example. In actual operation, a correspondence between a logic state and a resistance value may be designed in logic as required, and the correspondence between a logic state and a resistance value of a magnetic tunnel junction may even be changed in a term of a physical result by using a device such as a phase inverter.

A working principle of the voltage-controlled write operation is as follows: A voltage that is of appropriate magnitude and in a direction is applied to both sides of the magnetic tunnel junction, so that negative electric charges are accumulated on an interface between the free ferromagnetic layer 11 and the magnetic tunnel barrier 13, to change magnetic anisotropy of an interface of the free ferromagnetic layer 11. As a result, the direction of the magnetic moment of the free ferromagnetic layer 11 reverses, to complete the write operation. It should be noted that regardless of a write "0" operation or a write "1" operation, both the directions of the voltages applied to both the sides of the magnetic tunnel junction are the same. Each time the voltage that is of appropriate magnitude and in a direction is applied, the magnetic moment of the free ferromagnetic layer reverses once, a magneto-resistance value changes, and a logic state corresponding to the magnetic tunnel junction changes once, for example, changes to the logic state "1" from the logic state "0", or changes to the logic state "0" from the logic state "1".

Still refer to the part 110 in FIG. 1. For example, when the magneto-resistive random access memory cell 10 is in the logic state "0", the direction of the magnetic moment of the free ferromagnetic layer 12 is the same as the direction of the magnetic moment of the fixed ferromagnetic layer 11 are in a same direction, and the resistance of the magnetic tunnel junction is comparatively small. Assuming that a free ferromagnetic layer 12 end is connected to a negative electrode of a power supply, and a fixed ferromagnetic layer 11 end is connected to a positive electrode of the power supply, applying a voltage of appropriate magnitude to the two ends of the magnetic tunnel junction can cause the magnetic moment of the free ferromagnetic layer 12 to reverse. After the magnetic moment reverses, the magnetic moment of the free ferromagnetic layer 12 and the magnetic moment of the fixed ferromagnetic layer 11 are in opposite directions, the resistance of the magnetic tunnel junction is comparatively large, and the logic state of the magneto-resistive random access memory cell changes to "1".

As shown in the part 120 in FIG. 1, a principle of the read operation is as follows: A positive voltage is applied to the free ferromagnetic layer 12 of the magnetic tunnel junction, and a current resistance value of the magnetic tunnel junction is determined based on a generated read current I_{read}. Therefore, a current logic state of the magneto-resistive random access memory cell 10 is determined. For example, if the current resistance value of the magnetic tunnel junction is comparatively small, the logic state is "0"; or if the current resistance value of the magnetic tunnel junction is comparatively large, the logic state is "1". Because the positive voltage is applied to the free ferromagnetic layer 12 during the read operation, magnetic anisotropy of the interface of the free ferromagnetic layer 12 is enhanced, thereby increasing stability of the magnetic moment of the free ferromagnetic layer 12 in a reverse direction. Therefore, a read disturbance (read disturb) problem does not exist. Read disturbance means that when a negative voltage is applied to a free ferromagnetic layer end of a magneto-resistive random access memory, magnetic anisotropy of an interface of a free ferromagnetic layer is reduced. Consequently, a magnetic moment of the free ferromagnetic layer tends to reverse.

Optionally, the fixed ferromagnetic layer 11 and the free ferromagnetic layer 12 may include ferromagnetic metal. For example, the fixed ferromagnetic layer 11 and the free ferromagnetic layer 12 may include any one or any combination of the following materials: ferromagnetic materials such as cobalt iron boron (CoFeB), cobalt iron (CoFe), cobalt (Co), and iron (Fe).

Optionally, the magnetic tunnel barrier 13 may include a dielectric (dielectric). A type of the dielectric is not limited in this embodiment of this application. For example, the dielectric may be, for example, a crystalline oxide, a crystalline metal oxide, a non-crystalline oxide, or another type of dielectric. For example, the dielectric may include any one or any combination of the following materials: a magnesium oxide (MgO), an aluminum oxide (AlO), an aluminum nitride (AlN), a boron nitride (BN), a silicon oxide (SiO2), and the like.

It should be noted that to accumulate enough electric charges on an interface of a free ferromagnetic layer, a comparatively large leakage current should not flow through a magnetic tunnel barrier during a write operation. When a thickness of the magnetic tunnel barrier is determined, to generate enough electric charges on the interface of the free ferromagnetic layer, setting of a maximum value of a write-operation voltage needs to meet a condition that no obvious leakage current is generated. When the maximum write-operation voltage is not exceeded, a larger write-operation voltage corresponds to a faster write-operation speed and a lower write-operation error rate. Therefore, it is expected to maximally increase the write-operation voltage. For example, in an ideal case, the write-operation voltage can reach a supply voltage V_{DD} of a logic device of a chip. For a read operation, a read-operation voltage needs to be higher than the write-operation voltage, so that a voltage applied to a magnetic tunnel junction can generate a current flowing through the magnetic tunnel junction. Whether the magnetic tunnel junction is in a "0" state corresponding to a small resistance value or in a "1" state corresponding to a large resistance value may be determined based on a value of the current. In an ideal state, it is expected that the read-operation voltage does not exceed the supply voltage V_{DD} of the chip. Otherwise, an additional power supply needs to be provided to supply power for the read operation. In this case, a current problem is as follows: To meet a requirement of optimizing write-operation performance and set the write-operation voltage to the supply voltage V_{DD}, because the read-operation voltage needs to be higher than the write-operation voltage, an additional power supply needs to be provided to supply power for the read operation. This increases complexity in circuit design. If it is considered from a perspective of simplifying circuit design, the read-operation voltage is set to the supply voltage V_{DD}, and the write-operation voltage is set to be lower than the supply voltage V_{DD}. In this case, write-operation performance may be affected and cannot be better optimized.

In addition, compared with a conventional magneto-resistive random access memory supporting a current-controlled write operation, the magneto-resistive random access memory supporting a voltage-controlled write operation has a thicker magnetic tunnel barrier. Therefore, for devices of a same size, the magnetic tunnel junction of the voltage-controlled magneto-resistive random access memory has a larger resistance value. When a read operation is performed, excessively large resistance of the magnetic tunnel junction affects a speed of the read operation due to an RC delay. For example, a thickness of a magnetic tunnel barrier of a VCMA-MRAM is usually about 1.5 nanometers (nanometer, nm), and a thickness of a magnetic tunnel barrier of a spin-torque-transfer-MRAM (spin-torque-transfer-MRAM, STT-MRAM) is usually about 1 nm. For devices of a same size, resistance of a magnetic tunnel junction of the VCMA-MRAM is about tenfold that of a magnetic tunnel junction of the STT-MRAM

To resolve the foregoing problems that the magneto-resistive random access memory supporting a voltage-controlled write operation encounters a paradox existing in optimal voltage values set for a write operation and a read operation, and encounters a comparatively slow read-operation speed, the embodiments of this application provide a new magneto-resistive random access memory cell and memory structure. In the structure, a quantum well structure with two tunnel barriers is used to replace a conventional magnetic tunnel barrier structure with a single barrier, to form a magnetic tunnel junction with a resonant tunneling effect.

FIG. 2 is a schematic structural diagram of a magneto-resistive random access memory cell 20 according to still another embodiment of this application. A hollow arrow in FIG. 2 indicates a direction of a magnetic moment of a fixed ferromagnetic layer 21 or a direction of a magnetic moment of a free ferromagnetic layer 22. As shown in FIG. 2, the magneto-resistive random access memory cell 20 includes:
the fixed ferromagnetic layer 21, the free ferromagnetic layer 22, and a magnetic tunnel barrier 23, where the magnetic tunnel barrier 23 is located between the fixed ferromagnetic layer 21 and the free ferromagnetic layer 22, the magnetic tunnel barrier 23 includes a quantum well with two tunnel barriers that includes a first barrier layer 41, a conductive layer 43, and a second barrier layer 42, and the conductive layer 43 is disposed between the first barrier layer 41 and the second barrier layer 42.

Optionally, interfaces of the fixed ferromagnetic layer 21, the magnetic tunnel barrier 23, and the free ferromagnetic layer 22 are in contact with one another. Optionally, some processing may be performed on an interface at which the free ferromagnetic layer 22 and the magnetic tunnel barrier 23 are in contact, to increase magnetic anisotropy of the free ferromagnetic layer 22. For example, metal doping may be performed on the interface at which the free ferromagnetic layer 22 and the magnetic tunnel barrier 23 are in contact.

The quantum well with two tunnel barriers may be referred to as a double-barrier quantum well or a resonant tunneling barrier, or may be referred to as a quantum well for short in this embodiment of this application. The quantum well with two tunnel barriers may be understood as a barrier structure with a resonant tunneling effect. A principle of the resonant tunneling effect is that energy level distribution is discontinuous in a quantum well with a finite barrier height. It is assumed that a first quantum well energy level is E₁. Values and distribution that are of energy levels of a quantum well may be adjusted based on a barrier height V₀ of the quantum well, a barrier width D of the quantum well, and a width L of the quantum well. Therefore, energy distribution of carriers (for example, electrons) in the quantum well is also discontinuous. A lowest energy level of the carriers is E₁. When voltages V_{bias} on two ends of the quantum well are comparatively low, a Fermi energy level E_{F} of electrons is lower than E₁, and only energy levels of quite few thermally excited electrons can reach E₁. According to a quantum effect, only those quite few electrons whose energy levels are equal to E₁ can pass through the quantum well by using the tunneling effect. In other words, when the voltages V_{bias} on the two ends of the quantum well are comparatively low, the Fermi energy level E_{F} of the electrons is lower than E₁, and a current passing through the quantum well is quite small. When the voltages V_{bias} on the two ends of the quantum well increase, a quantity of electrons whose energy levels are equal to E₁ increases, a quantity of electrons passing through the quantum well by using the tunneling effect increases accordingly, and the current passing through the quantum well also increases accordingly. When the voltages V_{bias} on the two ends of the quantum well continue to increase until the Fermi energy level E_{F} of electrons is equivalent to E₁, a quantity of electrons whose energy levels are equal to E₁ reaches a maximum value, and the current passing through the quantum well also reaches a local maximum value accordingly. The voltage V_{bias} (eV_{bias} = E₁) in this case is a resonance voltage. Continuing to increase the voltages V_{bias} on the two ends of the quantum well results in a decrease in a quantity of electrons whose energy levels are equal to E₁. Consequently, the current passing through the quantum well also decreases accordingly and reaches a minimum value. However, when the voltages V_{bias} on the two ends of the quantum well are higher than the height V₀ of the quantum well, the current passing through the quantum well starts to increase as the voltages V_{bias} on the two ends of the quantum well increase, and exceeds the local maximum value.

Optionally, the quantum well may be a metal quantum well. That is, the conductive layer 43 may be made based on metal or magnetic metal. For example, the conductive layer may include any one or any combination of the following materials: metal materials and metal compounds such as cobalt iron boron (CoFeB), cobalt iron (CoFe), iron (Fe), cobalt (Co), platinum (Pt), and tantalum (Ta).

Alternatively, the quantum well may be a semiconductor quantum well. That is, the conductive layer 43 may be made based on a magnetic or non-magnetic semiconductor. For example, the conductive layer may include any one or any combination of the following materials: semiconductor materials of silicon (Si), silicon germanium (SiGe), germanium (Ge), a II-VI compound, a III-V compound, and another compound.

Optionally, materials of the first barrier layer 41 and the second barrier layer 42 may include a dielectric (dielectric). A type of the dielectric is not limited in this embodiment of this application. For example, the dielectric may be, for example, a crystalline oxide, a crystalline metal oxide, a non-crystalline oxide, or another type of dielectric. For example, the dielectric may include any one or any combination of the following materials: a crystalline magnesium oxide (MgO), an aluminum oxide (AlO), an aluminum nitride (AlN), a boron nitride (BN), a silicon oxide (SiO₂), and the like.

Optionally, the fixed ferromagnetic layer 21 and the free ferromagnetic layer 22 include ferromagnetic metal. For example, the fixed ferromagnetic layer 21 and the free ferromagnetic layer 22 include any one or any combination of the following materials: ferromagnetic materials such as cobalt iron boron (CoFeB), cobalt iron (CoFe), cobalt (Co), and iron (Fe).

In an example, materials constituting the first barrier layer 41 and the second barrier layer 42 may include a magnesium oxide (MgO). A material constituting the fixed ferromagnetic layer 21, the free ferromagnetic layer 22, and the conductive layer 43 may include any one or any combination of the following materials: ferromagnetic materials such as cobalt iron boron (CoFeB), cobalt iron (CoFe), cobalt (Co), and iron (Fe). As an example rather than a limitation, thicknesses of the first barrier layer 41 and the second barrier layer 42 that include MgO may be 0.5 nm to 2 nm, and a thickness of the conductive layer 43 including CoFeB may be 0.5 nm to 2 nm. A person skilled in the art can understand that based on different materials or different requirements for performance of the magnetic tunnel barrier, the thicknesses of the first barrier layer 41, the second barrier layer 42, and the conductive layer 43 may alternatively be within other value ranges, but need to meet a condition of forming a quantum well with discontinuous energy levels. Optionally, if the quantum well is a semiconductor quantum well, the materials constituting the first barrier layer 41, the conductive layer 43, and the second barrier layer 42 need to be compatible with a semiconductor material. For example, when silicon (Si) is used as the material of the conductive layer 43 of the semiconductor quantum well, a silicon oxide (SiO₂) may be used as the materials of the first barrier layer 41 and the second barrier layer 42. Optionally, the magnetic tunnel barrier may have a symmetrical structure. For example, dimensions of the first barrier layer 41 and the second barrier layer 42 may be the same, and the materials constituting the first barrier layer 41 and the second barrier layer 42 may also be the same. Optionally, the magnetic tunnel barrier may alternatively have an asymmetrical structure. For example, dimensions of the first barrier layer 41 and the second barrier layer 42 may be different, and the materials constituting the first barrier layer 41 and the second barrier layer 42 may also be different. In an example in FIG. 2, a quantum well structure with two tunnel barriers is used to replace a conventional magnetic tunnel barrier structure with a single barrier. By using a negative differential resistance characteristic of a quantum well with two tunnel barriers, a write-operation voltage may be set to be higher than a read-operation voltage, thereby meeting a requirement of optimizing write-operation performance. In addition, because a current corresponding to the read-operation voltage is comparatively large, and a corresponding resistance value is comparatively small, an impact of an RC delay on a speed of a read operation is reduced.

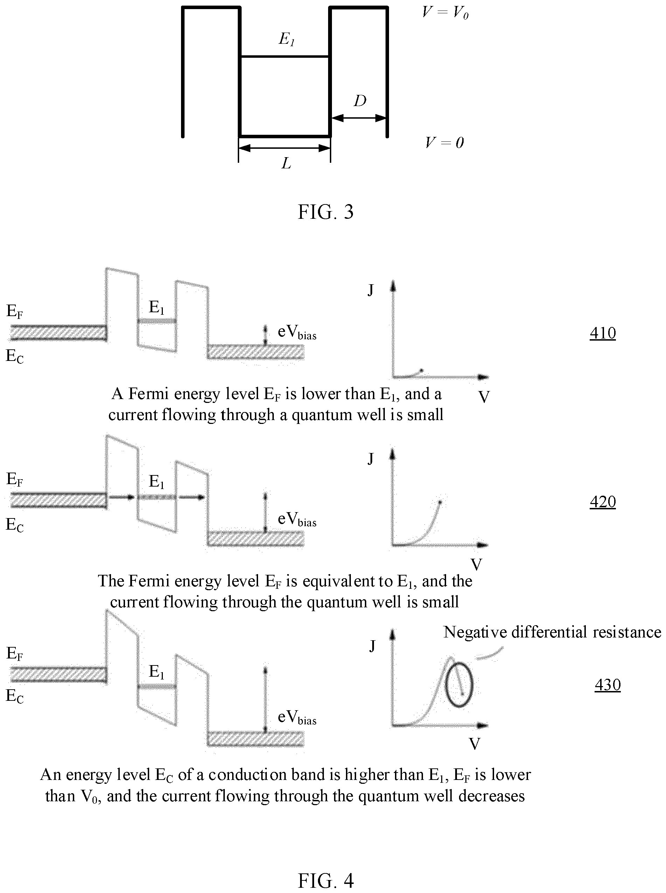

Specifically, FIG. 3 is a schematic diagram of energy level distribution of a quantum well with two tunnel barriers. As shown in FIG. 3, the quantum well is a quantum well with a finite barrier height. It is assumed that a barrier height is V₀, a barrier width is D, and a width of the quantum well is L. Values and distribution that are of energy levels of the quantum well may be adjusted based on the barrier height V₀ of the quantum well, the barrier width D of the quantum well, and the width L of the quantum well. Because energy level distribution is discontinuous in the quantum well, energy distribution of carriers (for example, electrons) in the quantum well is also discontinuous. For example, it is assumed that a lowest energy level in the quantum well is E₁.

FIG. 4 is a voltage-current characteristic diagram of the quantum well with two tunnel barriers. In FIG. 4, E_{F} represents a Fermi energy level of electrons, E_{C} represents an energy level of a conduction band, E₁ represents the lowest energy level in the quantum well, eV_{bias} represents band bending under a voltage V_{bias} applied to two ends of the quantum well, J represents density of a current flowing through the quantum well with two tunnel barriers, and V_{bias} represents the voltage applied to the two ends of the quantum well with two tunnel barriers.

As shown in a part 410 in FIG. 4, when the voltages V_{bias} on the two ends of the quantum well with two tunnel barriers are comparatively low, the Fermi energy level E_{F} is lower than the energy level E₁, the current flowing through the quantum well is comparatively small, and a resistance value is comparatively large.

As shown in a part 420 in FIG. 4, when the voltages V_{bias} on the two ends of the quantum well with two tunnel barriers increase, the Fermi energy level E_{F} is higher than the energy level E₁, and the energy level E_{C} at the bottom of the conduction band is lower than the energy level E₁. In this case, the current flowing through the quantum well increases, and the resistance value decreases.

As shown in a part 430 in FIG. 4, when the voltages V_{bias} on the two ends of the quantum well with two tunnel barriers continue to increase, both the Fermi energy level E_{F} and the energy level E_{C} at the bottom of the conduction band are higher than the energy level E₁, and V_{bias} is lower than V₀. In this case, the current flowing through the quantum well decreases, and the resistance value increases. Therefore, it can be learned from the part 430 in FIG. 4 that a voltage-current characteristic of the quantum well exhibits a negative differential resistance characteristic.

In addition, when the voltages V_{bias} on the two ends of the quantum well with two tunnel barriers continue to increase, V_{bias} becomes higher than the barrier height V₀. In this case, the current flowing through the quantum well starts to increase again, and the resistance value decreases.

Therefore, based on the foregoing analysis, it can be learned that the voltage-current characteristic of the quantum well with two tunnel barriers is nonlinear. For example, in the part 420 in FIG. 4, the current is comparatively large, and the voltage V_{bias} is comparatively small, whereas in the part 430 in FIG. 4, the current is comparatively small, and the voltage V_{bias} is comparatively large. Therefore, the voltage V_{bias} in the part 420 in FIG. 4 may be set as a read-operation voltage, and the voltage V_{bias} in the part 430 in FIG. 4 may be set as a write-operation voltage. Because the voltage-current characteristic of the quantum well with two tunnel barriers is nonlinear, the write-operation voltage may be set to be higher than the read-operation voltage, thereby meeting a requirement of optimizing write-operation performance. In addition, because a current corresponding to the read-operation voltage is comparatively large, and a corresponding resistance value is comparatively small, an impact of an RC delay on a speed of a read operation is reduced.

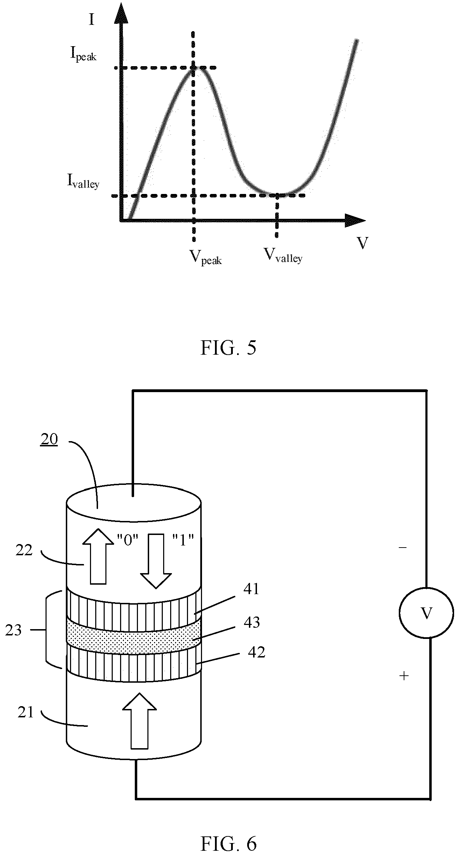

FIG. 5 is a voltage-current characteristic diagram of a quantum well with two tunnel barriers according to still another embodiment of this application. A horizontal coordinate V represents a voltage applied to two ends of the quantum well with two tunnel barriers, and a vertical coordinate represents a current flowing through the quantum well. As shown in FIG. 5, before the voltage V applied to the two ends of the quantum well causes the quantum well to be broken down, it is assumed that a maximum current is Iₚₑₐₖ, a voltage corresponding to the maximum current is Vₚₑₐₖ, a minimum current is I_{valley}, and a voltage corresponding to the minimum current is V_{valley}. Optionally, V_{valley} may be set as an optimal write-operation voltage, and Vₚₑₐₖ may be set as an optimal read-operation voltage. Assuming that a write-operation voltage is represented by V_{W}, and a read-operation voltage is represented by V_{R}, the foregoing relationships may be expressed as V_{W} = V_{valley} and V_{R} = Vₚₑₐₖ.

It may be understood that the foregoing values are merely an example rather than a limitation. For example, another appropriate value may be selected for the write-operation voltage from an interval centered on V_{valley}, and another appropriate value may be selected for the read-operation voltage from an interval centered on Vₚₑₐₖ.

FIG. 6 is a schematic diagram of a write operation of a magneto-resistive random access memory cell according to an embodiment of this application. A hollow arrow in FIG. 6 indicates a direction of a magnetic moment of a fixed ferromagnetic layer 21 or a direction of a magnetic moment of a free ferromagnetic layer 22. As shown in FIG. 6, for a write "0" operation, a negative voltage may be applied in a direction from the free ferromagnetic layer 22 to the fixed ferromagnetic layer 21. To be specific, the free electromagnetic layer 22 is connected to a negative electrode of a power supply, and the fixed ferromagnetic layer 21 is connected to a positive electrode of the power supply. Magnitude of the negative voltage may be, for example, V_{valley}, or another appropriate voltage value may be selected based on a description of FIG. 5. Similarly, for a write "1" operation, a negative voltage may also be applied in the direction from the free ferromagnetic layer 22 to the fixed ferromagnetic layer 21. Magnitude of the negative voltage may be, for example, V_{valley}, or another voltage value may be selected based on the description of FIG. 5. It should be noted that regardless of the write "0" operation or the write "1" operation, directions of voltages applied to a magnetic tunnel barrier are the same. Each time a write operation is performed, the magnetic moment of the free ferromagnetic layer may reverse once, and a resistance value increases or decreases accordingly, so that a status of the memory cell changes to "1" from "0", or changes to "0" from " 1". By using a negative differential resistance characteristic of a quantum well with two tunnel barriers, a write-operation voltage may be set to be higher than a read-operation voltage. A large write-operation voltage can increase a write-operation speed and reduce a write-operation error rate, thereby implementing a high-speed and low-energy voltage-controlled write operation.

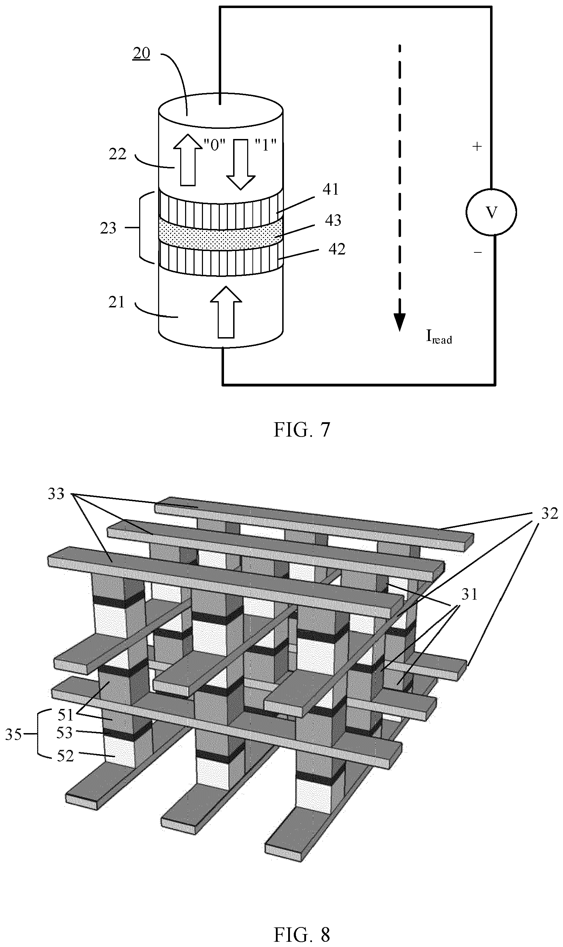

FIG. 7 is a schematic diagram of a read operation of a magneto-resistive random access memory cell according to an embodiment of this application. A hollow arrow in FIG. 7 indicates a direction of a magnetic moment of a fixed ferromagnetic layer 21 or a direction of a magnetic moment of a free ferromagnetic layer 22. A dashed-line arrow in FIG. 7 indicates a direction of a read-operation current I_{read} flowing through the magneto-resistive random access memory cell. As shown in FIG. 7, for a read operation, a positive voltage may be applied in a direction from the free ferromagnetic layer 22 to the fixed ferromagnetic layer 21. To be specific, the free ferromagnetic layer 22 is connected to a positive electrode of a power supply, and the fixed ferromagnetic layer 21 is connected to a negative electrode of the power supply. Magnitude of the positive voltage may be, for example, Vₚₑₐₖ, or another appropriate voltage value may be selected based on a description of FIG. 5. The selected read-operation voltage can implement that a resistance value of a magnetic tunnel barrier is comparatively low, thereby reducing an impact of an RC delay on a read speed, and providing a random access function of a high-speed and low-RC-delay read operation.

It can be learned from the foregoing analysis that the magneto-resistive random access memory in FIG. 2 uses the negative differential resistance characteristic of the quantum well with two tunnel barriers, thereby implementing construction of a novel resonant tunnel magneto-resistive random access memory device, and combines advantages (high speed and low power consumption) of the voltage-controlled write operation with the high-speed and low-RC-delay read operation, thereby implementing provision of a high-performance and high-storage-density magneto-resistive random access memory.

Based on the foregoing described magneto-resistive random access memory cell supporting a voltage-controlled write operation, an embodiment of this application provides a three-dimensional stacking (3 dimensional stacking) magneto-resistive random access memory architecture, to increase storage density and reduce a chip area and chip costs. The following describes the memory architecture in detail with reference to the accompanying drawings and a specific embodiment.

FIG. 8 is a schematic architectural diagram of a three-dimensional stacking magneto-resistive random access memory 30 according to an embodiment of this application. The three-dimensional stacking magneto-resistive random access memory 30 includes:
a memory layer 31, where a plurality of magnetic memory cells 35 are disposed in the memory layer 31; and
two metal layers 32 adjacent to the memory layer 31, where the two metal layers 32 are separately located on two sides of the memory layer 31, the two metal layers 32 include metallic wires 33, and the metallic wires 33 in the two metal layers 32 are separately coupled to two poles of the magnetic memory cell 35 in the memory layer 31. The magnetic memory cell 35 may be a magneto-resistive random access memory cell supporting a voltage-controlled write operation. For example, the magnetic memory cell 35 may be the magneto-resistive random access memory cell in FIG. 1 or FIG. 2, or may be another type of magneto-resistive random access memory cell supporting a voltage-controlled write operation. This is not limited in this embodiment of this application.

Optionally, the foregoing coupling may mean that the metallic wires 33 are electrically connected to the two poles of the magnetic memory cell 35.

As shown in FIG. 8, the magnetic memory cell 35 includes a fixed ferromagnetic layer 51, a free ferromagnetic layer 52, and a magnetic tunnel barrier 53. A structure of the magnetic tunnel barrier 53 may be shown in FIG. 1 or FIG. 2. The two poles of the magnetic memory cell 35 may be a fixed ferromagnetic layer 51 end and a free ferromagnetic layer 52 end. For example, the two poles of the magnetic memory cell 35 are separately a first pole and a second pole. The first pole of the magnetic memory cell 35 may be the free ferromagnetic layer 52 end, and the second pole of the magnetic memory cell 35 may be the fixed ferromagnetic layer 51 end. Alternatively, the first pole of the magnetic memory cell 35 may be the fixed ferromagnetic layer 51 end, and the second pole of the magnetic memory cell 35 may be the free ferromagnetic layer 52 end.

Optionally, the plurality of magnetic memory cells 35 may be arranged in a two-dimensional array. Optionally, a dielectric layer may be further disposed between the plurality of memory layers 31 and the plurality of metal layers 32. The dielectric layer is configured to isolate the memory layer 31 from the metal layer 32. Existence of the dielectric layer does not affect an electrical connection between the memory layer 31 and the metal layer 32.

Optionally, there may be one or more memory layers 31. For example, as shown in FIG. 8, the memory 30 may include a plurality of memory layers 31 and a plurality of metal layers 32. Each memory layer 31 is disposed between two metal layers 32 and is adjacent to the two metal layers 32. Each metal layer 32 is connected to one pole of a magnetic memory cell 35 in an adjacent memory layer 31, to transmit a signal used for performing a read/write operation on the magnetic memory cell 35.

It may be understood as that the plurality of memory layers 31 and the plurality of metal layers 32 are distributed at intervals, and one memory layer 31 is disposed between every two metal layers 32. The metal layer 32 may include a plurality of metallic wires 33. Each metallic wire 33 is connected to a magnetic memory cell 35 in an adjacent memory layer 31. Specifically, the metallic wire 33 may be connected to a fixed ferromagnetic layer 51 or a free ferromagnetic layer 52 in the magnetic memory cell 35, so that a write-operation voltage or a read-operation voltage can be applied to two ends of the magnetic memory cell 35 through the metallic wire 33.

Optionally, the magnetic memory cell 35 may be disposed at a cross point (cross point) between metallic wires 33 in adjacent metal layers 32. For example, the plurality of metallic wires 33 disposed in each metal layer 32 may be parallel to each other, metallic wires 33 disposed in adjacent metal layers 32 may be perpendicular to each other, and the magnetic memory cell 35 may be disposed at a cross point between metallic wires 33 in adjacent metal layers 32. For example, as shown in FIG. 8, the magnetic memory cells 35 in each memory layer 31 are distributed in a two-dimensional array. The magnetic memory cells 35 in each memory layer 31 are in a plurality of rows and a plurality of columns. It is assumed that metal layers 32 adjacent to each memory layer 31 are separately a first metal layer 32 and a second metal layer 32. In this case, a plurality of metallic wires 33 in the first metal layer 32 may correspond to the plurality of rows of magnetic memory cells 35, that is, each metallic wire 33 is connected to one row of magnetic memory cells 35; and a plurality of metallic wires 33 in the second metal layer 32 may correspond to the plurality of columns of magnetic memory cells 35, that is, each metallic wire 33 is connected to one column of magnetic memory cells 35. In other words, each magnetic memory cell 35 corresponds to one metallic wire 33 in the first metal layer 32 and one metallic wire 33 in the second metal layer 32. The metallic wire in the first metal layer 32 may be coupled to a first pole of the magnetic memory cell 35, and the metallic wire in the second metal layer 32 may be coupled to a second pole of the magnetic memory cell 35. If a read/write operation needs to be performed on a magnetic memory cell 35, two metallic wires 33 corresponding to the magnetic memory cell 35 may be selected, and a corresponding read-operation voltage or write-operation voltage may be applied to the two metallic wires 33.

It may be understood that for the plurality of memory layers 31, a quantity of memory layers may range from 2 up to a number subject to a process limitation, for example, 128 or another larger number.

Optionally, the magnetic memory cell 35 may be a magnetic memory cell supporting a voltage-controlled write operation. In other words, in a circuit, a power supply for the magnetic memory cell to perform a write operation is a voltage source. The voltage source may be a power source that can provide a stable and constant voltage.

In this embodiment of this application, in a manner of supporting the voltage-controlled write operation, an area of a single magnetic memory cell in the memory layer 31 is less than an area of another type of magnetic memory cell. For example, the area of the single magnetic memory cell in the memory layer 31 may reach a theoretical minimum value 4F². In contrast, an area of a magnetic memory cell in an STT-MRAM is greater than 60F², where F may represent half of the pitch (half of the pitch), and the pitch is a minimum spacing between center lines of two cells in a design rule. In addition, the magnetic memory cell 35 supporting a voltage-controlled write operation may use a three-dimensional stacking solution. The STT-MRAM uses a manner of supporting a current-controlled write operation. Limited by a read-operation principle and a write-operation principle, the another type of memory cell such as the STT-MRAM cannot use the simple three-dimensional stacking solution, and instead, requires a complex selector (selector) used to limit a current. Therefore, the three-dimensional stacking magneto-resistive random access memory in this embodiment of this application can have a higher storage density, thereby reducing a chip area and chip costs. Optionally, orientations of the plurality of magnetic memory cells 35 in the memory layer 31 may be the same or different. This is not limited in this embodiment of this application. The orientation may be a direction from the fixed ferromagnetic layer 51 to the free ferromagnetic layer 52 in the magnetic memory cell 35, or a direction from the free ferromagnetic layer 52 to the fixed ferromagnetic layer 51 in the magnetic memory cell 35. The orientation may be upward, downward, or at another angle. This is not limited in this embodiment of this application.

In some examples, orientations of the magnetic memory cells 35 in each memory layer 31 are the same, or orientations of magnetic tunnel junctions of the magnetic memory cells 35 are the same. For example, orientations of free ferromagnetic layers 52 in magnetic memory cells 35 in a memory layer 32 are the same. In some examples, orientations of free ferromagnetic layers 52 in magnetic memory cells 35 in different memory layers 32 may be the same or opposite.

For example, as shown in FIG. 8, in an example, magnetic memory cells 35 in adjacent memory layers 31 are distributed in a mirrored manner. To be specific, fixed ferromagnetic layers 51 in the magnetic memory cells 35 in the adjacent memory layers 31 are opposite to each other, or free ferromagnetic layers 52 in the magnetic memory cells 35 in the adjacent memory layers 31 are opposite.

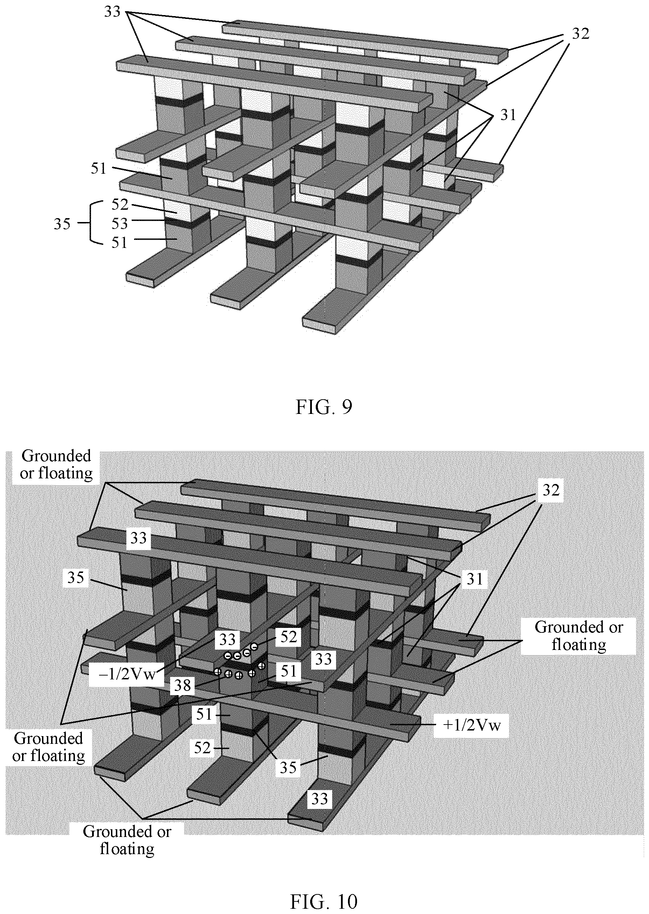

For another example, in another example, FIG. 9 is a schematic architectural diagram of a three-dimensional stacking magneto-resistive random access memory according to still another embodiment of this application. As shown in FIG. 9, orientations of magnetic memory cells 35 in adjacent memory layers 31 may be the same, which may also be referred to as non-mirrored distribution. In other words, a fixed ferromagnetic layer 51 in a magnetic memory cell 35 is opposite to a free ferromagnetic layer 52 in a magnetic memory cell 35 in an adjacent memory layer 31.

The following continues to describe the write-operation principle and the read-operation principle of the magneto-resistive random access memory in this embodiment of this application.

FIG. 10 is a schematic diagram of a write operation of a magneto-resistive random access memory according to an embodiment of this application. Magnetic memory cells 35 in adjacent memory layers 31 in FIG. 10 are distributed in a mirrored manner. As shown in FIG. 10, if a first magnetic memory cell 38 is selected for a write operation, a first negative voltage (for example, ―1/2Vw in FIG. 10) may be applied to a metallic wire 33 connected to a free ferromagnetic layer 52 end of the first magnetic memory cell 38, and a first positive voltage (for example, +1/2Vw in FIG. 10) may be applied to a metallic wire 33 connected to a fixed ferromagnetic layer 51 end of the first magnetic memory cell 38. In this case, the first magnetic memory cell 38 performs the write operation. The first magnetic memory cell 38 is any one of the plurality of magnetic memory cells 35.

A voltage difference between the first positive voltage and the first negative voltage is a write-operation voltage Vw. In other words, the write -operation voltage Vw is applied to the first magnetic memory cell 38 through the two metallic wires connected to the first magnetic memory cell 38.

In addition, to avoid miswriting another magnetic memory cell 35 that is not selected for the write operation, at least one of metallic wires 33 connected to two poles of the not-selected magnetic memory cell 35 should be set to be grounded or floating. "Grounded" may be understood as that the metallic wire is connected to a ground potential. "Floating" may be understood as an open circuit, that is, an end of the metallic wire is not connected to any electrical node.

In addition, configurations of the first positive voltage and the first negative voltage should ensure that a maximum difference between voltages induced on two sides of another magnetic memory cell 35 does not exceed a critical voltage V_{C}. The critical voltage V_{C} may be a critical voltage V_{C} that causes a magnetic moment of a free ferromagnetic layer 52 in the magnetic memory cell 35 to reverse. In other words, an absolute value of the first positive voltage and an absolute value of the first negative voltage should not exceed the critical voltage Vc.

It should be noted that when the at least one of the metallic wires connected to the magnetic memory cell 35 that is not selected for the write operation is set to be floating, there is no difference between voltages at two ends of the magnetic memory cell 35, because the not-selected magnetic memory cell 35 does not form a loop with the ground. Therefore, in this case, there is no need to consider the critical voltage Vc when the first positive voltage and a second positive voltage are set. In other words, the absolute value of the first positive voltage or the absolute value of the first negative voltage may exceed the critical voltage V_{C}. In an example, when the at least one of the metallic wires 33 connected to the magnetic memory cell 35 that is not selected for the write operation is floating, it is only required that a difference between the voltages applied to the two ends of the magnetic memory cell 35 is the write-operation voltage. For example, the voltage applied to the free ferromagnetic layer 52 end may be ―V_{w}, and the voltage applied to the fixed ferromagnetic layer 51 end may be 0; or the voltage applied to the free ferromagnetic layer 52 end may be 0, and the voltage applied to the fixed ferromagnetic layer 51 end may be +V_{w}.

Still refer to FIG. 10. As a specific example rather than a limitation, the first positive voltage is equal to +Vw/2, and the first negative voltage is equal to -Vw/2, where Vw represents the write-operation voltage of the magnetic memory cell 35. Therefore, a difference between the voltages on two sides of a magnetic tunnel junction of the first magnetic memory 38 is V_{W}. When the at least one of the metallic wires 33 connected to the another magnetic memory cell 35 that does not perform the write operation is grounded, a voltage induced by the free ferromagnetic layer 52 of the another magnetic memory cell 35 is ―V_{W}/2 or 0. Generally, an absolute value of the critical voltage V_{C} that causes a magnetic moment of a magnetic memory cell 35 to reverse is greater than Vw/2. Therefore, the magnetic memory cell 35 that is not selected for the write operation is not miswritten.

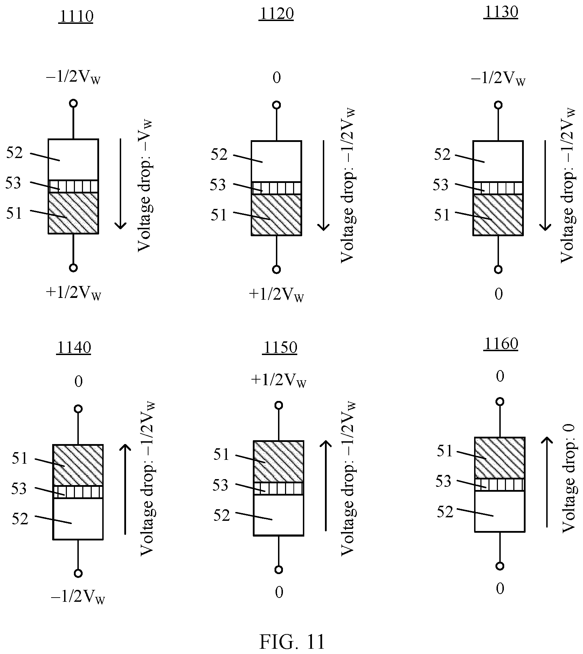

FIG. 11 is a schematic diagram of potential distribution of different magnetic memory cells 35 during the write operation. The potential distribution diagram in FIG. 11 corresponds to FIG. 10. It is assumed that at least one of metallic wires connected to a magnetic memory cell 35 that is not selected for the write operation in FIG. 11 is grounded.

Specifically, a part 1110 in FIG. 11 is a potential distribution diagram of the first magnetic memory cell 38 that is selected for the write operation. The voltage at the fixed ferromagnetic layer 51 end of the first magnetic memory cell 38 is +1/2V_{W}, and the voltage at the free ferromagnetic layer 52 end of the first magnetic memory cell 38 is ―1/2V_{W}. Therefore, the voltage drop between the two ends of the magnetic tunnel junction is -Vw. In this case, a magnetic moment of a free ferromagnetic layer 52 in the first magnetic memory cell 38 reverses, and the first magnetic memory cell 38 performs the write operation.

A part 1120 in FIG. 11 is a potential distribution diagram of a magnetic memory cell 35 that is in a same memory layer 31 as the first magnetic memory cell 38 and that is connected to the same metallic wire 33 applying +1/2V_{W}. A voltage at a fixed ferromagnetic layer 51 end of the magnetic memory cell 35 is +1/2V_{W}, and a voltage at a free ferromagnetic layer 52 end of the magnetic memory cell 35 is 0. Therefore, a voltage drop between two ends of a magnetic tunnel junction is ―1/2V_{W}, which is lower than a critical voltage V_{C} that causes a magnetic moment to reverse. In this case, a magnetic moment of a free ferromagnetic layer 52 does not reverse.

A part 1130 in FIG. 11 is a potential distribution diagram of a magnetic memory cell 35 that is in a same memory layer 31 as the selected first magnetic memory cell 38 and that is connected to the same metallic wire 33 applying ―1/2V_{W}. A voltage at a fixed ferromagnetic layer 51 end of the magnetic memory cell 35 is 0, and a voltage at a free ferromagnetic layer 52 end of the magnetic memory cell 35 is ―1/2V_{W}. Therefore, a voltage drop between two ends of a magnetic tunnel junction is ―1/2V_{W}, which is lower than a critical voltage V_{C} that causes a magnetic moment to reverse. In this case, a magnetic moment of a free ferromagnetic layer 52 does not reverse.

A part 1140 in FIG. 11 is a potential distribution diagram of a magnetic memory cell 35 that is located in a memory layer 31 adjacent to the selected first magnetic memory cell 38 and that is connected to the same metallic wire 33 applying ―1/2V_{W}. A voltage at a fixed ferromagnetic layer 51 end of the magnetic memory cell 35 is 0, and a voltage at a free ferromagnetic layer 52 end of the magnetic memory cell 35 is ―1/2V_{W}. Therefore, a voltage drop between two ends of a magnetic tunnel junction is ―1/2V_{W}, which is lower than a critical voltage V_{C} that causes a magnetic moment to reverse. In this case, a magnetic moment of a free ferromagnetic layer 52 does not reverse.

A part 1150 in FIG. 11 is a potential distribution diagram of a magnetic memory cell 35 that is located in a memory layer 31 adjacent to the selected first magnetic memory cell 38 and that is connected to the same metallic wire 33 applying +1/2Vw. A voltage at a fixed ferromagnetic layer 51 end of the magnetic memory cell 35 is +1/2Vw, and a voltage at a free ferromagnetic layer 52 end of the magnetic memory cell 35 is 0. Therefore, a voltage drop between two ends of a magnetic tunnel junction is ―1/2V_{W}, which is lower than a critical voltage V_{C} that causes a magnetic moment to reverse. In this case, a magnetic moment of a free ferromagnetic layer 52 does not reverse.

Apart 1160 in FIG. 11 is a potential distribution diagram of a magnetic memory cell 35 that does not share a metallic wire with the first magnetic memory cell 38. Both a voltage at a fixed ferromagnetic layer 51 end of the magnetic memory cell 35 and a voltage at a free ferromagnetic layer 52 end of the magnetic memory cell 35 are 0. Therefore, a voltage drop between two ends of a magnetic tunnel junction is 0. In this case, a magnetic moment of a free ferromagnetic layer 52 does not reverse.

Based on analysis about FIG. 11, it can be learned that in this embodiment of this application, with appropriate configuration of the first positive voltage and the first negative voltage that are applied to the metallic wires, a magneto-resistive random access memory does not miswrite the other magnetic memory cells 35 when performing a write operation on the selected first magnetic memory cell 38.

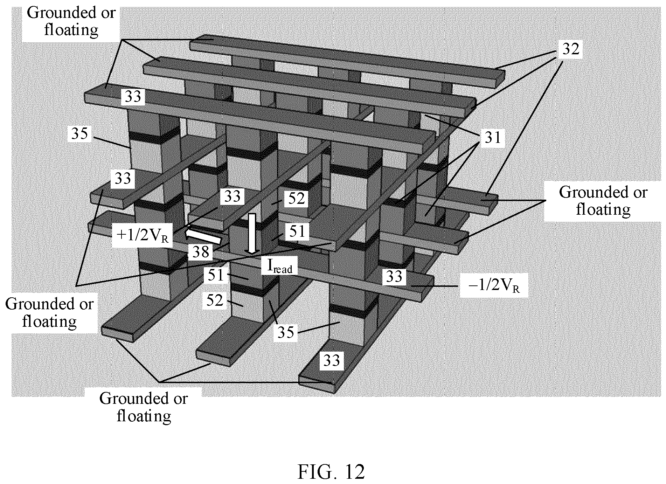

FIG. 12 is a schematic diagram of a read operation of a magneto-resistive random access memory according to an embodiment of this application. Magnetic memory cells 35 in adjacent memory layers 31 in FIG. 12 are distributed in a mirrored manner. As shown in FIG. 12, if a first magnetic memory cell 38 is selected for a read operation, a second positive voltage may be applied to a metallic wire 33 connected to a free ferromagnetic layer 52 end of the first magnetic memory cell 38, and a second negative voltage may be applied to a metallic wire connected to a fixed ferromagnetic layer 51 end of the first magnetic memory cell 38. In this case, the first magnetic memory cell performs the read operation. The first magnetic memory cell 38 is any one of the plurality of magnetic memory cells 35.

A voltage difference between the second positive voltage and the second negative voltage is a read-operation voltage V_{R}. In other words, the read-operation voltage V_{R} is applied to the first magnetic memory cell 38 through the two metallic wires 33 connected to the first magnetic memory cell 38. In this case, the first magnetic memory cell 38 performs the read operation.

In addition, to avoid disturbing another magnetic memory cell 35 that is not selected for the read operation, at least one of metallic wires connected to the not-selected magnetic memory cell 35 should be set to be grounded or floating. In addition, to avoid a waste of power resulting from that a magnetic tunnel junction of the magnetic memory cell 35 that is not selected for the read operation generates a current, selection of the second positive voltage and the second negative voltage should ensure that the magnetic tunnel junction of the not-selected magnetic memory cell 35 does not generate an obvious current. In other words, an absolute value of the second positive voltage and an absolute value of the second negative voltage do not exceed a threshold voltage V_{T}. The threshold voltage V_{T} may be a threshold voltage that causes a magnetic tunnel junction of a magnetic memory cell 35 to generate an obvious current.

It should be noted that when the at least one of the metallic wires connected to the magnetic memory cell 35 that is not selected for the read operation is set to be floating, there is no difference between voltages at two ends of the magnetic memory cell 35, because the not-selected magnetic memory cell 35 does not form a loop with the ground. Therefore, in this case, there is no need to consider the threshold voltage V_{T} during setting of the second positive voltage and a second positive voltage. In other words, the absolute value of the second positive voltage or the absolute value of the second negative voltage may exceed the threshold voltage V_{T}. For example, in an example, when the at least one of the metallic wires connected to the magnetic memory cell 35 that is not selected for the read operation is floating, it is only required that a difference between the voltages applied to the two ends of the magnetic memory cell 35 is the read-operation voltage. For example, the voltage applied to the free ferromagnetic layer 52 end may be V_{R}, and the voltage applied to the fixed ferromagnetic layer 51 end may be 0; or the voltage applied to the free ferromagnetic layer 52 end may be 0, and the voltage applied to the fixed ferromagnetic layer 51 end may be ―V_{R}.

It should be noted that for a case in which magnetic memory cells 35 in adjacent memory layers 31 are distributed in the mirrored manner, when a read operation is performed on the first magnetic memory cell 38, a voltage induced by a free ferromagnetic layer 52 of the another not-selected magnetic memory cell 35 is a positive voltage or 0. Because applying a positive voltage to the free ferromagnetic layer 52 end can enhance magnetic anisotropy of an interface of the free ferromagnetic layer 52, a magnetic moment of the free ferromagnetic layer 52 of the another magnetic memory cell 35 is stable and does not reverse. Therefore, miswriting resulting from a disturbance effect generated by the read operation does not occur.

Still refer to FIG. 12. As a specific example rather than a limitation, the second positive voltage is equal to +V_{R}/2, and the second negative voltage is equal to ―V_{R}/2, where V_{R} represents the read-operation voltage of the magnetic memory cell 35. Therefore, a difference between the voltages on two sides of a magnetic tunnel junction of the first magnetic memory 38 is V_{R}. When the at least one of the metallic wires 33 connected to the another magnetic memory cell 35 that does not perform the read operation is grounded, the voltage induced by the free ferromagnetic layer 52 of the another magnetic memory cell 35 is +V_{R}/2 or 0. Generally, an absolute value of the threshold voltage V_{T} of the magnetic memory cell 35 is greater than V_{R}/2. Therefore, the magnetic memory cell 35 that is not selected for the read operation does not generate an obvious large current, and there is no waste of power.

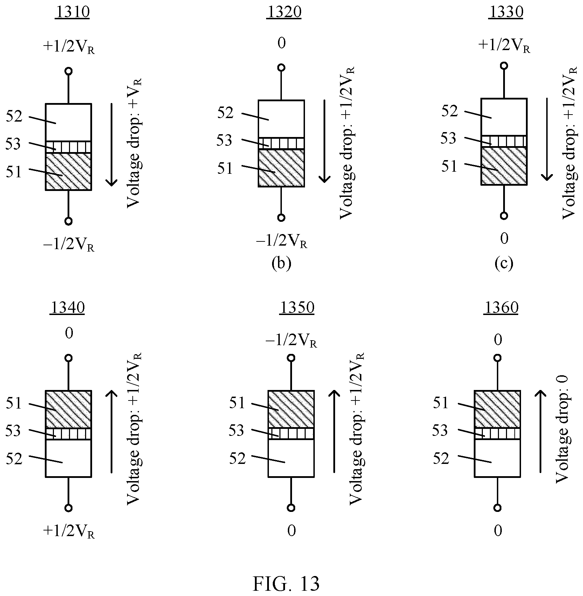

FIG. 13 is a schematic diagram of potential distribution of different magnetic memory cells 35 during the read operation. The potential distribution diagram in FIG. 13 corresponds to FIG. 12. It is assumed that at least one of metallic wires connected to a magnetic memory cell 35 that is not selected for the read operation in FIG. 13 is grounded. Specifically, a part 1310 in FIG. 13 is a potential distribution diagram of the first magnetic memory cell 38 that is selected for the read operation. The voltage at the fixed ferromagnetic layer 51 end of the first magnetic memory cell 38 is ―1/2V_{R}, and the voltage at the free ferromagnetic layer 52 end of the first magnetic memory cell 38 is +1/2V_{R}. Therefore, the voltage drop between the two ends of the magnetic tunnel junction is +V_{R}. In this case, the first magnetic memory cell 38 performs the read operation.

A part 1320 in FIG. 13 is a potential distribution diagram of a magnetic memory cell 35 that is in a same memory layer 31 as the first magnetic memory cell 38 and that is connected to the same metallic wire 33 applying ―1/2V_{R}. A voltage at a fixed ferromagnetic layer 51 end of the magnetic memory cell 35 is ―1/2V_{R}, and a voltage at a free ferromagnetic layer 52 end of the magnetic memory cell 35 is 0. Therefore, a voltage drop between two ends of a magnetic tunnel junction is +1/2V_{R}.

A part 1330 in FIG. 13 is a potential distribution diagram of a magnetic memory cell 35 that is in a same memory layer 31 as the first magnetic memory cell 38 and that is connected to the same metallic wire 33 applying +1/2V_{R}. A voltage at a fixed ferromagnetic layer 51 end of the magnetic memory cell 35 is 0, and a voltage at a free ferromagnetic layer 52 end of the magnetic memory cell 35 is ―1/2V_{R}. Therefore, a voltage drop between two ends of a magnetic tunnel junction is +1/2V_{R}.

A part 1340 in FIG. 13 is a potential distribution diagram of a magnetic memory cell 35 that is located in a memory layer 31 adjacent to the selected first magnetic memory cell 38 and that is connected to the same metallic wire 33 applying +1/2V_{R}. A voltage at a fixed ferromagnetic layer 51 end of the magnetic memory cell 35 is 0, and a voltage at a free ferromagnetic layer 52 end of the magnetic memory cell 35 is +1/2V_{R}. Therefore, a voltage drop between two ends of a magnetic tunnel junction is +1/2V_{R}.

A part 1350 in FIG. 13 is a potential distribution diagram of a magnetic memory cell 35 that is located in a memory layer 31 adjacent to the selected first magnetic memory cell 38 and that is connected to the same metallic wire 33 applying ―1/2V_{R}. A voltage at a fixed ferromagnetic layer 51 end of the magnetic memory cell 35 is ―1/2V_{R}, and a voltage at a free ferromagnetic layer 52 end of the magnetic memory cell 35 is 0. Therefore, a voltage drop between two ends of a magnetic tunnel junction is +1/2V_{R}.

A part 1360 in FIG. 13 is a potential distribution diagram of a magnetic memory cell 35 that does not share a metallic wire with the first magnetic memory cell 38. Both a voltage at a fixed ferromagnetic layer 51 end of the magnetic memory cell 35 and a voltage at a free ferromagnetic layer 52 end of the magnetic memory cell 35 are 0. Therefore, a voltage drop between two ends of a magnetic tunnel junction is 0.

Based on analysis about FIG. 13, it can be learned that in this embodiment of this application, with appropriate configuration of the second positive voltage and the second negative voltage that are applied to the metallic wires 33, a magneto-resistive random access memory does not interfere with or miswrite the other magnetic memory cells 35 when performing a read operation on the selected first magnetic memory cell 38.

FIG. 10 to FIG. 13 describe a read-operation principle and a write-operation principle in a scenario in which magnetic memory cells 35 in adjacent memory layers 31 have mirror symmetry. A person skilled in the art can understand that a read-operation principle and a write-operation principle in a scenario in which magnetic memory cells 35 in adjacent memory layers 31 do not have mirror symmetry, as shown in FIG. 9, are the same as or similar to the read-operation principle and the write-operation principle in the preceding scenario. However, in a case of non-mirror symmetry, a free ferromagnetic layer 52 in a magnetic memory cell 35 is opposite to a fixed ferromagnetic layer 51 in a magnetic memory cell 35 in an adjacent memory layer 31. Therefore, in a case of a read operation, when a positive voltage is applied to a metallic wire 33 connected to a free ferromagnetic layer 52 end of a magnetic memory cell 35, it is equivalent to applying the same positive voltage to a fixed ferromagnetic layer 51 end of a magnetic memory cell 35 that is in an adjacent memory layer and that shares the metallic wire 33, and it is also equivalent to that a negative voltage of same magnitude is applied to a free ferromagnetic layer 52 of the adjacent magnetic memory cell 35. As described above, when a negative voltage is applied to a free ferromagnetic layer end of a magneto-resistive random access memory, magnetic anisotropy of an interface of a free ferromagnetic layer is reduced. Consequently, a magnetic moment of the free ferromagnetic layer tends to reverse, that is, read disturbance. Therefore, during the read operation, how to avoid a read disturbance problem needs to be considered. For example, in a process of reading a selected first magnetic memory cell 38, for voltages applied to metallic wires 33 connected to two ends of the first magnetic memory cell 38, it should be ensured that voltages induced by two ends of an adjacent magnetic memory cell 35 are less than a critical voltage V_{C} that causes a magnetic moment to reverse. For example, if at least one of metallic wires 33 connected to a magnetic memory cell 35 that is not selected for the read operation is grounded, an absolute value of the voltage applied to either end of the first magnetic memory cell 38 should be less than the critical voltage V_{C}. Alternatively, if at least one of metallic wires 33 connected to a magnetic memory cell 35 that is not selected for the read operation is floating, there is no need to consider the critical voltage Vc when the voltages to be applied to the two ends of the first memory cell 38 are determined, because the magnetic memory cell 35 does not form a loop with the ground.

It should be further noted that when magnetic memory cells 35 in adjacent memory layers 31 do not have mirror symmetry, during a write operation, to avoid a waste of power resulting from that a magnetic tunnel junction of a magnetic memory cell 35 that is not selected for the write operation generates a current, determining of voltages applied to two ends of a first memory cell 38 that performs the write operation should ensure that the magnetic tunnel junction of the not-selected magnetic memory cell 35 does not generate an obvious current. For example, when at least one of metallic wires connected to the not-selected magnetic memory cell 35 is grounded, an absolute value of the voltage applied to either end of the first memory cell 38 should not exceed a threshold voltage V_{T}. The threshold voltage V_{T} may be a threshold voltage that causes a magnetic tunnel junction of a magnetic memory cell 35 to generate an obvious current. Alternatively, when at least one of metallic wires connected to the not-selected magnetic memory cell 35 is floating, there is no need to consider the threshold voltage V_{T}.

Therefore, the magnetic memory cell 35 that is not selected for the write operation does not generate an obvious large current, and there is no waste of power.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, comprising:
a memory layer, wherein a plurality of magnetic memory cells are disposed in the memory layer; and
two metal layers adjacent to the memory layer, wherein the two metal layers are separately located on two sides of the memory layer, the two metal layers comprise metallic wires, and the metallic wires in the two metal layers are separately coupled to two poles of the magnetic memory cell in the memory layer.

2. The memory according to claim 1, wherein orientations of the magnetic memory cells in the memory layer are the same.

3. The memory according to claim 1 or 2, wherein the magnetic memory cells in the memory layer are arranged in a two-dimensional matrix.

4. The memory according to claim 3, wherein each of the two metal layers comprises a plurality of metallic wires disposed in parallel, and the two metal layers comprise a first metal layer and a second metal layer, wherein
the plurality of metallic wires in the first metal layer are in a one-to-one correspondence with a plurality of rows in the two-dimensional matrix, and the metallic wire in the first metal layer is coupled to a first pole of a magnetic memory cell in a corresponding row; and
the plurality of metallic wires in the second metal layer are in a one-to-one correspondence with a plurality of columns in the two-dimensional matrix, and the metallic wire in the second metal layer is coupled to a second pole of a magnetic memory cell in a corresponding column.

5. The memory according to claim 4, wherein the magnetic memory cell is disposed at a cross point between the metallic wire in the first metal layer and the metallic wire in the second metal layer.

6. The memory according to any one of claims 1 to 5, wherein the magnetic memory cell comprises a plurality of memory layers and a plurality of metal layers, and each of the plurality of memory layers comprises a plurality of memory cells; and
each memory layer is disposed between two metal layers and is adjacent to the two metal layers, the two metal layers comprise metallic wires, and the metallic wires in the two metal layers are separately coupled to two poles of the magnetic memory cell in each memory layer.

7. The memory according to claim 6, wherein magnetic memory cells in two adjacent memory layers are distributed in a mirrored manner.

8. The memory according to claim 6, wherein orientations of magnetic memory cells in two adjacent memory layers are the same.

9. The memory according to any one of claims 1 to 8, wherein the magnetic memory cell is a magnetic memory cell supporting a voltage-controlled write operation.

10. The memory according to any one of claims 1 to 9, wherein the first pole of the magnetic memory cell is a free ferromagnetic layer end; the second pole of the magnetic memory cell is a fixed ferromagnetic layer end; and when a first negative voltage is applied to a first pole of a first magnetic memory cell, and a first positive voltage is applied to a second pole of the first magnetic memory cell, the first magnetic memory cell performs a write operation, wherein a voltage difference between the first positive voltage and the first negative voltage is a write-operation voltage of the magnetic memory cell, and the first magnetic memory cell is any one of the plurality of magnetic memory cells.

11. The memory according to claim 10, wherein the first positive voltage is equal to +V_{W}/2, and the first negative voltage is equal to -Vw/2, wherein Vw represents the write-operation voltage of the magnetic memory cell.

12. The memory according to any one of claims 1 to 9, wherein the first pole of the magnetic memory cell is a free ferromagnetic layer end; the second pole of the magnetic memory cell is a fixed ferromagnetic layer end; and when a second positive voltage is applied to a first pole of a first magnetic memory cell, and a second negative voltage is applied to a second pole of the first magnetic memory cell, the first magnetic memory cell performs a read operation, wherein a voltage difference between the second positive voltage and the second negative voltage is a read-operation voltage of the magnetic memory cell, and the first magnetic memory cell is any one of the plurality of magnetic memory cells.

13. The memory according to claim 12, wherein the second positive voltage is equal to +V_{R}/2, and the second negative voltage is equal to ―V_{R}/2, wherein V_{R} represents the read-operation voltage of the magnetic memory cell.

14. The memory according to any one of claims 1 to 13, wherein the magnetic memory cell comprises:
a free ferromagnetic layer;
a fixed ferromagnetic layer; and
a magnetic tunnel barrier, wherein the magnetic tunnel barrier is located between the fixed ferromagnetic layer and the free ferromagnetic layer, and comprises a first barrier layer, a conductive layer, and a second barrier layer.

15. The memory according to claim 14, wherein the first barrier layer and the second barrier layer comprise a dielectric, and the conductive layer comprises a conductive material.

16. The memory according to claim 14 or 15, wherein the first barrier layer and the second barrier layer comprise a crystalline metal oxide.

17. The memory according to any one of claims 14 to 16, wherein a material used by the first barrier layer and the second barrier layer comprises a magnesium oxide MgO, and a material used by the conductive layer comprises cobalt iron boron CoFeB.

18. The memory according to any one of claims 14 to 17, wherein the magnetic tunnel barrier has a symmetrical structure.

19. A memory access method, wherein a memory comprises: a memory layer, wherein a plurality of magnetic memory cells are disposed in the memory layer, and two metal layers adjacent to the memory layer, wherein the two metal layers are separately located on two sides of the memory layer, the two metal layers comprise metallic wires, and the metallic wires in the two metal layers are separately coupled to two poles of the magnetic memory cell in the memory layer; a first pole of the magnetic memory cell is a free ferromagnetic layer end, and a second pole of the magnetic memory cell is a fixed ferromagnetic layer end; and the method comprises:
when a write operation is performed, applying a first negative voltage to a metallic wire connected to a first pole of a first magnetic memory cell, and applying a first positive voltage to a metallic wire connected to a second pole of the first magnetic memory cell, wherein the first magnetic memory cell is any one of the plurality of magnetic memory cells, and a voltage difference between the first positive voltage and the first negative voltage is a write-operation voltage of the magnetic memory cell; or
when a read operation is performed, applying a second positive voltage to a metallic wire connected to a first pole of a first magnetic memory cell, and applying a second negative voltage to a metallic wire connected to a second pole of the first magnetic memory cell, wherein a voltage difference between the second positive voltage and the second negative voltage is a read-operation voltage of the magnetic memory cell.

20. The method according to claim 19, wherein the first positive voltage is equal to +Vw/2, and the first negative voltage is equal to -Vw/2, wherein Vw represents the write-operation voltage of the magnetic memory cell.

21. The method according to claim 19 or 20, wherein the second positive voltage is equal to +V_{R}/2, and the second negative voltage is equal to ―V_{R}/2, wherein V_{R} represents the read-operation voltage of the magnetic memory cell.

22. An integrated circuit, comprising the memory according to any one of claims 1 to 18.
